Europäisches Patentamt

European Patent Office

Office européen des brevets

(11) Publication number: **0 135 594 B1**

# EUROPEAN PATENT SPECIFICATION

(45) Date of publication of patent specification: **06.05.92**  (51) Int. Cl.5: **H01S 3/19**, H01S 3/085

(21) Application number: **84900883.4**

(22) Date of filing: **22.02.84**

(86) International application number:
**PCT/JP84/00063**

(87) International publication number:
**WO 84/03398 (30.08.84 84/21)**

(54) SEMICONDUCTOR LASER.

(30) Priority: **22.02.83 JP 28379/83**

(43) Date of publication of application:
**03.04.85 Bulletin 85/14**

(45) Publication of the grant of the patent:
**06.05.92 Bulletin 92/19**

(84) Designated Contracting States:
**DE FR GB NL**

(56) References cited:
**JP-A- 5 373 090**

**ELECTRONICS LETTERS, vol. 14, no. 24, 23rd November 1978, pages 753,754, London, GB; T. IKEGAMI et al.:" Planar stripe with waist/notch (Swan)injection laser"**

**JOURNAL OF APPLIED PHYSICS, vol. 46, no. 4, April 1975, pages 1660-1672, American Institute of Physics, New York, US; D.D. COOK et al.: "Gain-induced guiding and astigmatic output beam of GaAs lasers"**

(73) Proprietor: **SONY CORPORATION**
**7-35 Kitashinagawa 6-Chome Shinagawa-ku Tokyo 141(JP)**

(72) Inventor: **MAMINE, Takayoshi Sony Corporation**
**7-35, Kitashinagawa 6-chome Shinagawa-ku Tokyo 141(JP)**
Inventor: **YONEYAMA, Osamu Sony Corporation**
**7-35, Kitashinagawa 6-chome Shinagawa-ku Tokyo 141(JP)**

(74) Representative: **Thomas, Christopher Hugo et al**
**D Young & Co 10 Staple Inn**
**London WC1V 7RD(GB)**

**JOURNAL OF APPLIED PHYSICS, vol. 54, no. 8, August 1983, pages 4302-4304, New York, US; Takayoshi Mamine et al.: "New class of gain guiding laser with a tapered-stripe structure"**

**IEEE JOURNAL OF OUANTUM ELECTRONICS, vol. 16, no. 1 (January 1980) (New York), H. KAWAGUCHI and T. IKEGAMI, p. 78-84, esp. see Fig. 6 and Fig. 13**

## Description

This invention relates to semiconductor lasers suitable for use as a light source of a recording and/or reproducing apparatus such as an optical video disc or a digital audio disc apparatus.

Prior art semiconductor lasers are roughly classified into an index-guiding type and a gain-guiding type, on the basis of the optical confinement mechanism in the horizontal direction of the hetero-junction, or the waveguide mechanism.

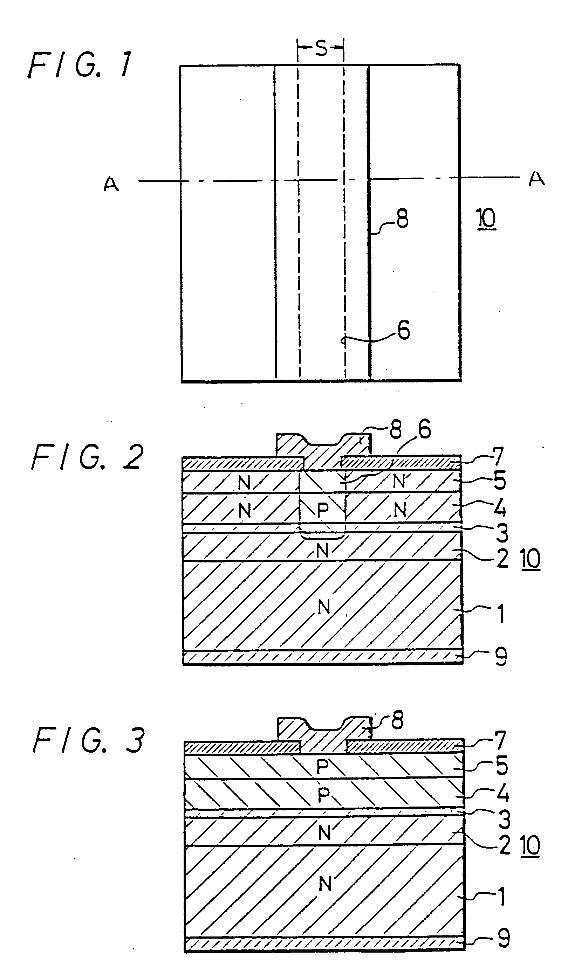

As an example of a semiconductor laser of index-guiding type, a semiconductor laser 10 is shown in schematic enlarged plan view in Figure 1 and in cross-sectional view in Figure 2 taken along a line A-A in Figure 1. The semiconductor laser 10 is formed such that on a GaAs substrate 1 of N type, a first clad layer 2 made of N type $Al_yGa_{1-y}As$, an active layer 3 made of N type $Al_xGa_{1-x}As$, a second clad layer 4 similarly made of N type $Al_yGa_{1-y}As$ and a GaAs capping layer 5 of N type are epitaxially grown in turn and formed at, for example, the centre thereof is a high refractive index layer 6 of stripe pattern which is extended in one direction by introducing thereinto Zn as impurity of P type by selective implantation. The depth of the high refractive index layer 6 is such as to enter the active layer 3 or to enter the first clad layer 2 by several hundred nm. Formed on the surface of the capping layer 5 is an insulating layer 7 made of $SiO_2$ or the like and through an electrode window formed therethrough, one electrode 8 is deposited in ohmic contact on the high refractive index layer 6, while another electrode 9 is similarly deposited in ohmic contact on the back surface of the substrate 1. As described above, a difference of refractive index is formed between the portions of the active layer 3 in which the layer 6 exists and no layer exists, whereby an oscillation area of light is restricted to a stripe pattern.

An example of a gain-guiding semiconductor laser of a planar stripe type is shown in Figure 3. Also in this case, the semiconductor laser is formed such that on the GaAs substrate 1 of, for example, N type, the first clad layer 2 made of N type $Al_yGa_{1-y}As$ is formed, and thereon the active layer 3 made of N type or P type $Al_xGa_{1-x}As$, the second clad layer 4 made of P type $Al_yGa_{1-y}As$ and the P type GaAs capping layer 5 are epitaxially grown in turn. At, for example, the centre thereof is deposited in ohmic contact the electrode 8 of stripe shape which is similarly extended in the direction perpendicular to the plane of Figure 2 through an electrode window of stripe pattern made through the insulating layer 7 which is deposited on the capping layer 5. The other electrode 9 is deposited in ohmic contact on the back surface of the substrate 1. In this semiconductor laser, an operating current is concentrated by the stripe-patterned electrode 8 and by this operating current injected closely beneath the stripe-patterned electrode 8, an oscillation area of similar stripe pattern is formed within the active layer 3. That is, the lateral mode is determined by the gain distribution caused by the concentration distribution of the carriers injected into the active layer 3 in the lateral direction.

In the prior art semiconductor laser of this kind having such a stripe structure, the width S of the oscillation area of stripe pattern is made uniform throughout each portion as shown in Figure 1.

Each of these lasers has an advantage, while neither is free from defects.

More particularly, in the index-guiding laser, its longitudinal mode is a single mode so that when it is used as a writing (recording) or reading(reproducing) light source, for example, for an optical video disc, there is then a defect that it is susceptible to noise caused by return light. On the other hand, since a so-called beam waist position, namely, an imaginary light source position exists near the light emission surface of the laser, there is then an advantage that when such a laser is used in practice, the position of a focus can be set with ease. Further, since a far field image, namely, a so-called far field pattern in the cross-section relative to the direction parallel to the junction is symmetrical with respect to left and right, for example, when such a laser is used in practice as a reading or writing light source which is converged by an optical system such as an objective lens thereby to form a very small beam spot, there is then an advantage that a beam spot having small distortion can easily be obtained.

As compared therewith, the imaginary light source position in a gain-guiding laser exists on the light end surface of the light-emission area regarding the light in the direction perpendicular to the junction, while regarding the light in the direction parallel to the junction, it exists at a position about 20 $\mu$m inside the light end surface of the light-emission area. Moreover, the far field pattern is asymmetrical with respect to left and right, and the astigmatism is large, so that it is disadvantageous for obtaining a very small beam spot having a small distortion. In this laser, however, the longitudinal mode is a multi-mode, resulting in the advantage that noise caused by the return light has less influence, as does mode hopping noise. IEEE J. Quant. Electronics 16(1), January 1980 discloses a gain-guided "Planar Stripe with Waist and/or Notch" (SWAN) Laser wherein the Stripe geometry consists of a main stripe section with narrower mode control sections near the facets which act as a lossy transverse mode filter.

EP 0 135 594 B1

JP-A-5373090 discloses a gain-guiding laser with a tapered stripe structure having the features of the preamble of claim 1.

According to the present invention there is provided a gain-guiding semiconductor laser of planar taper stripe structure comprising:

a semiconductor substrate having sequentially laminated on one major surface:

a first clad layer,

an active layer,

a second clad layer,

a capping layer, and

a first electrode of width S1 remote from a light end surface and S2 at said light end surface with an intervening portion where said width changes;

at least the envelope of said portion changing gently in a tapered manner in width from S1 to S2; and

a second electrode on the other major surface;

the distance of an imaginary source of light propagating parallel to a junction surface from said light end surface being D;

the radius of curvature of an equiphase surface of light emitted from said light end surface being R; and

the half-value width of a near field pattern of light on said light end surface being W; wherein when said W is selected to be a parameter, said D becomes maximum at a certain value of said R and when said W becomes larger, said D becomes larger;

characterized in that:

due to the fact that W is dependant on S2 and

R is dependent on S1; in order to decrease D, said S1 is made larger or smaller than a range in which said D becomes large, and said S2 is made small, to make said R large or small and to make said W small; and in that

the length of said portion is selected to make D less than 10 $\mu$m.

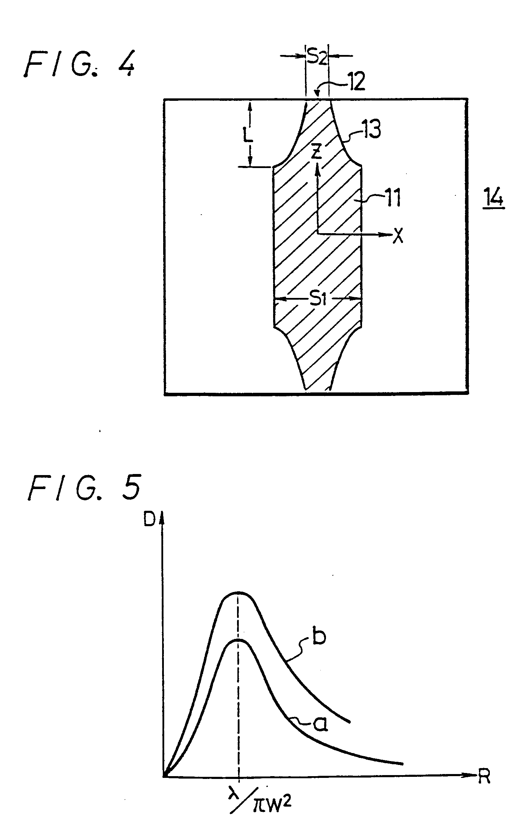

In embodiments of this invention, a semiconductor laser is formed as a gain-guiding type having a stripe structure. On a substrate such as, for example, described in connection with Figure 3, a first clad layer, an active layer, a second clad layer, a capping layer and the like are epitaxially grown in turn. The pattern of an ohmic contact portion of an electrode with the capping layer is formed as a stripe pattern with hatchings as shown by reference numeral 11 in Figure 4. This pattern is formed as a planar taper stripe structure in which the stripe width is S1 at the portion remote from a light end surface 12, and S2 on the light end surface, and also the width of the portion therebetween changes gently. Particularly in the semiconductor laser having such a structure, if the distance of the imaginary source of light propagating parallel to the junction surface from the light end surface 12 is taken as D, a radius of curvature of an equiphase surface of light emitted from the light end surface 12 is taken as R, and a half-value width of a near field pattern of light on the light end surface 12 is taken as W; then with W as a parameter, D becomes a maximum at a certain value of R, the larger W becomes the larger D becomes, the larger S1 becomes the larger R becomes, and the larger S2 becomes the larger W becomes. Accordingly, in order to make D small, S1 is made large or small taking its maximum value as a limit, S2 is made small, R is made large, and W is made small.

Modifications include an electrode stripe type in which the deposition pattern of an electrode is formed as a stripe pattern to concentrate a current, a junction stripe type in which a junction of a stripe pattern is formed by selective ion implantation or selective diffusing of impurity, and a proton irradiation type in which a high resistance region is formed by proton radiation so as to form a current path of stripe pattern.

The features of an embodiment of semiconductor laser according to this invention will be understood from the following explanation. That is, a beam emitted from a gain-guiding semiconductor laser such as explained with reference to Figure 3 generally has astigmatism. That is, in this semiconductor laser, the beam waist, namely, the imaginary source of the light propagating in the direction perpendicular to the junction exists on the high emission surface (the light end surface) of the semiconductor laser, while the imaginary source regarding the light propagating in the direction parallel to the junction exists inside the light end surface. If the distance of this imaginary light source from the light end surface is taken as D, then D corresponds to the amount of astigmatism and is given by:

$$D = R \left[ 1 + \left( \frac{\lambda R}{\pi W^2} \right)^2 \right]^{-1} \qquad \qquad \ldots (1)$$

4

where W is the half value-width ($l/e^2$ of width) of the near field pattern at the light end surface, R is the radius of curvature of the equiphase surface of light emitted into the air near and just at the light end surface, and $\lambda$ is the wavelength of that light.

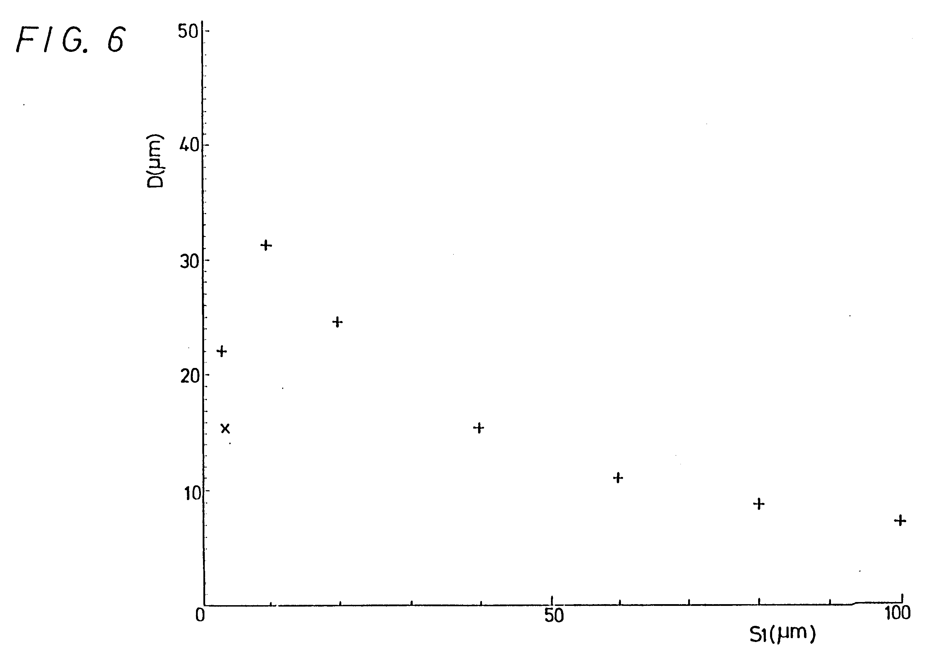

When, on the basis of equation (1) and the half value-width W as a parameter, the distance D is plotted by the function of the radius of curvature R, as, for example, shown by curves a and b in Figure 5, it is clear that the distance D takes a maximum value at a certain value of the radius of curvature R. The curve b shows a case where the half value-width W is larger than in the case of the curve a. As is clear from the above, in order to make the astigmatism, and accordingly, the distance D small, there are two methods:

(I) The half value-width W is made small and the radius of curvature R is made sufficiently large; and

(II) The half value-width W is made small and the radius of curvature R is made sufficiently small.

However, in practice, in the gain-guiding semiconductor laser of stripe type, each of the half value-width W and the radius of curvature R is dependent on the stripe width S expressed as:

$$W\alpha S^{\frac{1}{2}} , R\alpha S$$

Thus, the method (I) cannot be adopted immediately. That is, if the stripe width S is enlarged so as to make R large, W is made large in association therewith. On the contrary, according to the method (II), if the stripe width S is designed to be narrow, both of W and R can be made small so that the astigmatism can be made small. However, the fact that the stripe width is made narrow as above causes, in the light vs. current characteristic, the threshold value current density to be increased and the differentiation coefficient to be lowered, etc. Therefore, it is in practice difficult to obtain a semiconductor laser low in astigmatism and having good light vs. current characteristic and high reliability.

In a gain-guiding laser in which two resonators having the stripe widths S1 and S2 which are different from each other as shown in Figure 4 are arranged in series, the following items were known:

(a) The size of the near field pattern is determined by the stripe width S2 at the light end surface 12.

(b) The radius of curvature R of the equiphase surface is determined by the stripe width S1 at the centre portion side.

Then, from the items (a) and (b), the following results were obtained:

(A) If the central stripe width S1 is made sufficiently large and the stripe width S2 on the end surface is made small, this coincides with the method (I) for making the astigmatism small.

(B) If the width S1 is made small to an extent not to cause problems in practice in the range of S1 $\geq$ 5 to 10 $\mu$m and the width S2 is made sufficiently small, for example, 0.5 to 4 $\mu$m, this coincides with the method (II) for making the astigmatism small.

That is, in the case of the semiconductor laser of gain-guiding type structure, since the size of the near field pattern is determined by the gain-guiding width caused by the current flow in the direction parallel to the junction, namely, the so-called lateral direction, the size of the near field pattern tends to become larger than the stripe width. As compared therewith, according to the structure satisfying the above item (A), on the point that the near field pattern is small on the basis of (a) and (b) and the radius of curvature R of the equiphase surface is large, a result similar to the index-guiding type semiconductor laser is obtained. Thus, its astigmatism can be made small, for example, less than 10 $\mu$m. According to the semiconductor structure satisfying the above item (B), although this is a gain-guiding type structure, since the radius of curvature R on the equiphase surface of the light emitted from the light end surface becomes small, its astigmatism D lies within a range of 10 to 15 $\mu$m and the deterioration of characteristic, which is the problem inherent in the afore-mentioned narrow stripe type semiconductor laser is small, and so this semiconductor laser has good characteristics as the gain-guiding type semiconductor laser.

This invention is made on the basis of the considerations described in items (a) and (b) and these items (a) and (b) will be described.

In the semiconductor laser of so-called taper stripe type in which the stripe width of the oscillation area has the widths S2 and S1 which are respectively different on the light end surface 12 and the portion remote from the light end surface and its width is gently changed therebetween, let it be assumed that within the plane parallel to the junction surface, the extending direction of the stripe is taken as z, the direction perpendicular thereto is taken as x and the direction perpendicular to x and z is taken as y. In this case, it is assumed that the spatial gain distribution depends on x and z. Further, let it be assumed that the source of an electromagnetic wave exists at the centre of the stripe region 11, the stripe width be sufficiently wide and a resultant TE wave generated here is propagated to the taper portion substantially as a plane wave. A wave equation to be solved here is:

$$\nabla^2 E + k^2(x)E = 0 \qquad (2)$$

Now, in order to obtain the solution of this wave equation analytically, it is considered that the x dependence of the wave vector k be treated only as:

$k^2(x) = k^2 - kk_2x^2$
($k_2$ is complex number)     (3)

On the basis of these assumptions, let the following equation be considered:

$E = \psi(x, y, z)\, e^{-ikz}$     (4)

and solving the wave equation (2) yields:

$$\nabla t^2 \psi - 2ik\psi^{1'} - kk_2x^2\psi = 0 \qquad \cdots (5)$$

$$\left(\nabla t^2 \equiv \frac{\partial^2}{\partial \gamma^2} + \frac{1}{\gamma}\frac{\partial}{\partial \gamma}\right)$$

In the equation (5), let it be assumed that $\psi$ be expressed as:

$\psi(x, y, z) = \exp\left[-i\{P(z) + \frac{1}{2}Q(z)\cdot x^2\}\right]$     (6)

Substituting the equation (5) into the equation (4) yields:

$-Q^2x^2 - 2iQ - kx^2Q' - 2kP' - kk_2x^2 = 0$     (7)

In order to satisfy the equation (7) like an identity, the following equation must be established.

$$\left.\begin{array}{l} Q^2 + kQ' + kk_2 = 0 \\ P' = -iQ/k \end{array}\right\} \qquad \cdots (8)$$

To solve this equation (8), if $Q = kS'/S$ is assumed and then substituted into a differential equation regarding Q, the following equation is obtained:

$S'' + S(k_2/k) = 0$     (9)

The solution of this equation (9) is:

$$S(z) = a\,\sin\sqrt{\frac{k_2}{k}}\,z + b\,\cos\sqrt{\frac{k_2}{k}}\,z$$

Therefore:

$$S'(z) = a\,\sqrt{\frac{k_2}{k}}\,\cos\sqrt{\frac{k_2}{k}}\,z - b\,\sqrt{\frac{k_2}{k}}\,\sin\sqrt{\frac{k_2}{k}}\,z$$

is obtained. Thus, Q(z) becomes:

$$Q(z) = k \frac{a\sqrt{\frac{k_2}{k}} \cos\sqrt{\frac{k_2}{k}}\, z - b\sqrt{\frac{k_2}{k}} \sin\sqrt{\frac{k_2}{k}}\, z}{a \sin\sqrt{\frac{k_2}{k}}\, z + b \cos\sqrt{\frac{k_2}{k}}\, z} \qquad \cdots \ (10)$$

If, now, a new function $q(z) \equiv k/Q(z)$ is introduced and $q^{-1}(z)$ can be separated into a real number portion and an imaginary number portion, the following equation is established:

$$\frac{1}{q(z)} = \frac{1}{R(z)} - i\,\frac{\lambda}{\pi n W^2(z)} \qquad \cdots \ (11)$$

Here, R(z) becomes the radius of curvature of the equiphase surface of the light at the end in the z direction and W(z) becomes the beam spot width (half value-width) of the light in the z-axis direction. Now, a practical form of q (z) is searched for and the function on R(z) and W(z) is analyzed:

Assuming that the wave vector k depends on $x^2$:

$$k(x) = k \pm i\,(gp - \tfrac{1}{2}\,\alpha_2 x_2) \qquad (12)$$

is assumed to be satisfied (in which gp and $\alpha$ are real numbers). From the equations (3) and (4):

$$k(x) = (k^2 - k k_2 x^2)^{\frac{1}{2}} \simeq k - \tfrac{1}{2}\,k_2 x^2 \qquad (13)$$

is obtained.

Comparing these equations (12) and (13) yields:

$$k_2 = i\alpha_2 \qquad (14)$$

In this case, the practical form of $\alpha_2$ may be assumed, for example, as:

$$\frac{1}{2}\,\alpha_2 = \frac{4}{S^2}\,(gp + \alpha) \qquad \cdots \ (15)$$

(in which S is the stripe width).

Substituting the equation (14) into the equation (10) and obtaining q(z):

$$q(z) = \frac{q_o \cos\left(z\sqrt{\frac{\alpha_2}{2k}}\,(1+i)\right) + \tfrac{1}{2}(1-i)\sqrt{\frac{2k}{\alpha_2}} \cdot \sin\left(z\sqrt{\frac{\alpha_2}{2k}}\,(1+i)\right)}{-q_o(1+i)\sqrt{\frac{\alpha_2}{2k}} \sin\left(z\sqrt{\frac{\alpha}{2k}}(1+i)\right) + \cos\left(z\sqrt{\frac{\alpha_2}{2k}}\,(1+i)\right)}$$

$$\cdots \ (16)$$

is established

$$\text{(in which } q_o = \frac{i\pi W_o{}^2 n}{\lambda} \text{).}$$

If, now,

$$z\sqrt{\frac{\alpha_2}{2k}} \equiv Q$$

is set and the denominator and the numerator of q(z) of the equation (16) are respectively taken as A and B, which then are calculated:

$$A = -(q_o/z) (1+i) Q\sin \{(1+i)\theta\}+ \cos (1+i)\theta$$

$$= -(q_o/z) (1+i) \theta(\sin \theta \cos h\theta + i \cos \theta \sin h\theta)$$

$$+ (\cos \theta \cos h\theta - i \sin \theta \sin h\theta)$$

$$B = q_o \cos (1+i)\theta + \frac{1}{2}\frac{z}{\theta} (1-i) \sin (1+i)\theta$$

$$= q_o (\cos \theta \cos h\theta - \sin \theta \sin h\theta)$$

$$+ \frac{1}{2}\frac{z}{\theta} (1-i) (\sin \theta \cos h\theta + i \cos \theta \sin h\theta)$$

As will be understood from a later outlined numerical calculation, since $\theta < 1$ can be satisfied, the above A and B can be simplified as follows:

$$A = -(q_o/z)(1+i)\theta(\theta+i\theta) + (1-i\theta^2)$$

$$= -(q_o/z)2i\theta^2 + 1 - i\theta^2$$

$$= 1 - i\theta^2(1 + \frac{2q_o}{z})$$

$$B = q_o(i-i\theta^2) + \frac{1}{2}(z/\theta)(1-i)(\theta+i\theta)$$

$$= q_o(1-i\theta^2) + z$$

$$= q_o + z - i(q_o\theta^2)$$

thus:

$$q(z) = \frac{q_o + z - iq_o\theta^2}{1 - i\theta^2(1 + \frac{2q_o}{z})} \qquad \cdots (17)$$

Then, if $q_o \equiv i\pi W_0^2/\lambda \equiv iZ_0$ is satisfied and $Z_0$ is defined:

$$q(z) = \frac{iz_o + z + z_o\theta^2}{1 + \frac{2z_o}{z}\theta^2 - i\theta^2}$$

thus:

$$q^{-1}(z) = \frac{1 + \frac{2z_o}{z}\theta^2 - i\theta^2}{z + z_o\theta^2 + iz_o}$$

$$= \frac{z+2z_o\theta^2(1+\frac{z_o}{z})-i\{\frac{z_o}{z}(z+2z_o\theta^2)+\theta^2(z+z_o\theta^2)\}}{(z+z_o\theta)^2+z_o^2}$$

Therefore:

$$R(z) = \frac{(z + z_o\theta^2)^2 + z_o^2}{z + 2z_o\theta^2(1 + \frac{z_o}{z})}$$

$$W^2(z) = \frac{\lambda}{\pi n} \cdot \frac{(z + z_o\theta^2)^2 + z_o^2}{(z_o/z)(z + 2z_o\theta^2) + \theta^2(z + z_o\theta^2)}$$

$$R(z) = \frac{z^2(1 + z_o(\frac{\alpha_2}{2k})z)^2 + z_o^2}{z + z_o(\frac{\alpha_2}{k})(z_o \mp z)z} \quad \cdots \quad (18)$$

$$W^2(z) = \frac{1}{\pi n} \cdot \frac{z^2(1 + z_o(\frac{\alpha_2}{2k})z)^2 + z_o^2}{z_o(1 + 2z_o(\frac{\alpha_2}{2k})z) + (\frac{\alpha_2}{2k})z^3(1 + z_o(\frac{2k}{\alpha_2})z)} \quad \cdots \quad (19)$$

are obtained.

Subsequently, the effective distance D of the beam waist position, namely, the imaginary light source position from the light end surface will be considered.

Upon considering this distance D, a corresponding relation between a position at which the minimum value of the beam spot size within a practical cavity resonator is given and a position given by the measurement will be considered. If the half value-width W of the near field pattern on the light end surface and its emitting angle $\theta$ are given, the astigmatism of the semiconductor laser can be determined uniquely by a model in which $\alpha$ Gaussian beam can be propagated in a free space, and the astigmatism does not depend on the waveguide mechanism within the cavity resonator. Accordingly, even in, for example, a weak index-guiding type semiconductor laser, or a semiconductor laser in which the radius of curvature R on the equiphase surface of light emitted therefrom is finite, it is naturally expected that the imaginary light source distance D can be measured by the half value-width W of the near field pattern and its emitting angle $\theta$. Further, it is experimentally clear that the imaginary light source distance D of a generally obtainable index-guiding semiconductor laser at present has an astigmatism ranging from 4 to 8 $\mu$m. That is, the fact that the astigmatism of the index-guiding type semiconductor laser is small as compared with that of the gain-guiding type semiconductor laser is due to the fact that the spot width (half value-width) of the near field pattern in the index-guiding type laser is smaller than that of the gain-guiding type laser. Further, the above fact can easily be understood from the following fact that the beam waist position in the direction perpendicular to the junction, namely, in the longitudinal direction exists on substantially the light end surface position, the half value-width in this direction is about 0.3 $\mu$m and is very small as compared with that in the direction parallel to the junction, namely, the lateral direction and as compared with a difference of a refractive index regarding the lateral direction, a difference of a refractive index regarding the longitudinal direction being sufficiently large. Then, how the waveguide mechanism of each semiconductor laser participates in the beam waist is made clear pratically by solving the wave equation corresponding to each waveguiding mechanism and the half value-width W of the beam spot on the light end surface and the radius of curvature R of the equiphase surface of the light are independently determined. When the width W of the beam spot size on the light end surface and the radius of curvature R of the equiphase surface of light at the front end are determined as mentioned above, the emitting angle $\theta$ of the light is determined by an equation given as:

$$R = (\pi W^2/\lambda)\,[(\pi W_{\tan\theta}/\lambda) - 1]^{\frac{1}{2}} \quad (20)$$

...

and thus, owing to W and $\theta$, the light source distance D is finally determined as:

$$D = (\lambda/\pi \tan^2\theta) [(\pi W \tan\theta/\lambda)^2 - 1]^{\frac{1}{2}} \qquad (21)$$

From the above considerations, it can be understood that if the waveguide mechanism is given once and the electrode stripe pattern is given, the distance D is determined uniquely.

The above analysis clarifies for the first time the corresponding relation between the practical distribution of the light (or the TE wave) within the cavity resonator and the effective astigmatism produced by the measurement.

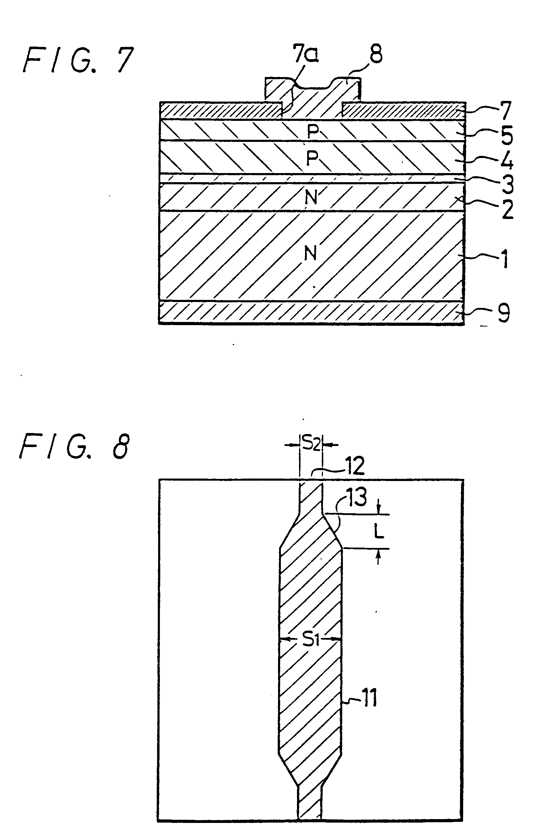

In the semiconductor laser of taper stripe type determined on the basis of the above analysis, or the semiconductor laser in which as shown in Figure 4, the stripe width is S1 at the central portion and S2 at the light end surface 12 and the width is gradually changed between the portion having the width S1 and the portion having the width S2 by the taper 13, the calculated results regarding the relation between the S1 determined when S2 = 3 $\mu$m is established and the light source distance D are shown by marks + in Figure 6. In the figure, a mark x indicates the calculated result of a semiconductor laser having the prior art structure in which the stripe width is selected to be the uniform width S1. In this case, qp + $\alpha \simeq 100$ cm$^{-1}$ and $\delta(\Delta n_p) = 1.1 \times 10^{-3}$ are set, and the value of D becomes considerably different depending on these parameters. These calculated results present data measured by the present inventors. From these calculated results, it is understood that in the case of the semiconductor laser having the taper stripe structure, the distance D of the imaginary light source, namely, the beam waist position from the light end surface can be made small to about 10 $\mu$m (the matter described in the above item (a)) by controlling the stripe width S2 on this light end surface, namely, the light-emitting portion, without depending on the stripe width S1 at the central side so much. The physical basis of the calculated results is as follows:

(i) Half value-width W of the near field pattern is small.

(ii) Radius of curvature R of the equiphase surface of light near the light end surface is small.

Considering the item (ii), it is easily confirmed that the light source distance D can be described by the half value-width W on the light end surface and the radius of curvature R as in the following equation:

$$D = (R/n) [1 + (\lambda R/n\pi W^2)^2]^{-1} \qquad (1)'$$

where R/n indicates the radius of curvature of the equiphase surface of light which propagates into the air just near the light end surface.

A relation between R/n and D expressed by the equation (1)' becomes the curve shown in Figure 5 and it is understood from this that D is decreased as R is decreased under the condition of (I') R/n < $\lambda/\pi W^2$, while D is decreased as R is increased under the condition of (II') R/n > $\lambda/\pi W^2$. These facts correspond to the afore-mentioned items (I) and (II). From the analyses as mentioned above, it is understood that in the taper stripe structure, if the taper length L is properly designed, it is possible to obtain a gain-guiding type semiconductor laser having astigmatism of D $\lesssim$ 10 $\mu$m.

The invention will now be described by way of example with reference to the accompanying drawings, throughout which like parts are referred to by like parts, and in which:

Figure 1 is an enlarged plan view of a prior art semiconductor laser;

Figure 2 is an enlarged cross-sectional view thereof;

Figure 3 is an enlarged cross-sectional view of another prior art example;

Figure 4 is a diagram showing a pattern of a stripe structure of a semiconductor laser according to the invention;

Figure 5 is a graph showing a relation between a radius of curvature of a front equiphase surface of an imaginary light source and a distance of a light source from a light end surface;

Figure 6 is a graph of calculated results for explaining this invention;

Figure 7 is an enlarged cross-sectional view of an embodiment of semiconductor laser according to this invention;

Figure 8 is a diagram showing a pattern of the stripe structure thereof;

Figure 9 is a graph indicating measured results of a relation between a taper length and an astigmastism amount; and

Figure 10 is a diagram showing a part of stripe structure of another embodiment of this invention.

Example 1

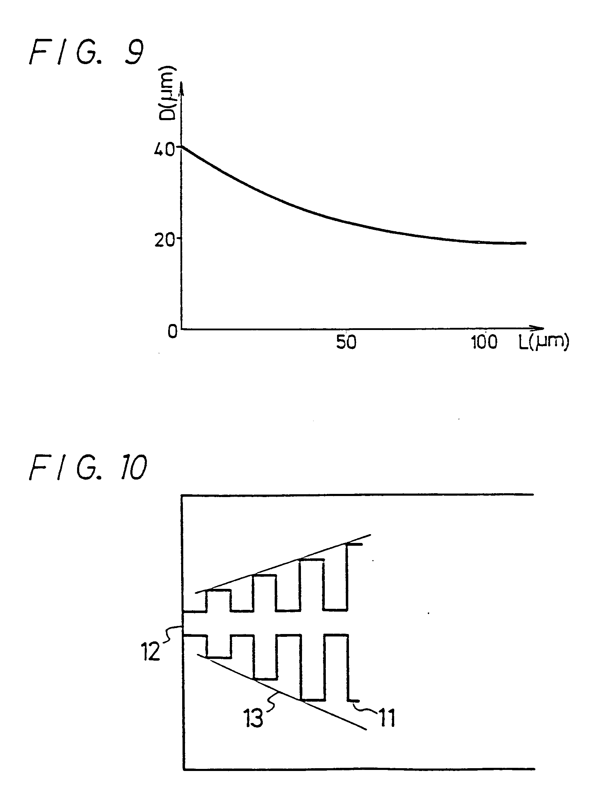

As shown in Figure 7, similarly to the manner explained in connection with Figure 3, respective semiconductive layers are epitaxially grown in turn on a GaAs substrate 1 by epitaxial method, for example, a vapour growth method using thermal decomposition. Explanation of parts in Figure 7 corresponding to those in Figure 3 will be omitted. In this case, the pattern of the portion in which the electrode 8 is deposited in ohmic contact with the capping layer 5, or the pattern of the electrode window 7a of the insulating layer 7 is formed such that as shown in Figure 8, the width of the central portion is selected to be S1, the width on the end surface 12 is selected to be S2 and both of them are connected straight together by a taper portion 13. When the length of this taper portion 13 is taken as L, S1 = 8 $\mu$m, S2 = 3 $\mu$m, the full length of the stripe was selected to be 250 $\mu$m and the length of the portion having the width S2 was selected to be 10 $\mu$m, planar stripe type lasers were formed in which L was respectively selected to be 10 $\mu$m, 20 $\mu$m, 40 $\mu$m, 80 $\mu$m and 125 $\mu$m.

Example 2

Semiconductor lasers were formed which have a similar structure to Example 1, but S1 = 6 $\mu$m, S2 = 3 $\mu$m and the full length of the stripe pattern was selected to be 250 $\mu$m, and in which L was similarly selected to be 10 $\mu$m, 20 $\mu$m, 40 $\mu$m and 80 $\mu$m, respectively.

Example 3

A semiconductor laser was formed to have a similar structure to Example 1 in which S1 = 20 $\mu$m, S2 = 3 $\mu$m, the full length of the stripe was selected to be 250 $\mu$m and L was selected to be 80 $\mu$m.

With all the Examples, semiconductor lasers were formed which were superior in threshold current, astigmatism, far field pattern, life time and the like.

Further, when the relation between the astigmatism D and the length L was measured, the results as shown in Figure 9 were obtained. According to the measured results, it is clear that L is preferably 100 $\mu$m to reduce the astigmatism.

Furthermore, in the embodiments, it was confirmed that the threshold value current density (threshold value current/electrode area) is decreased with the result that in the life time test, the deterioration ratio is decreased more than that of the ordinary semiconductor laser having the uniform stripe width of 5 $\mu$m.

The taper portion 13 can be formed as a straight line, parabola, hyperbola and the like, and the stripe portion 11 and the taper portion 13 can be connected smoothly. Further, the end portion of the taper portion 13 may have a portion with a uniform width.

While in the above examples the portion having the uniform width S1 and the portion having the different but uniform width S2 are coupled together by the taper portion 13, it is possible that as shown in Figure 10, the stripe portion 11 is formed as, for example, a zigzag pattern and the envelope of the pattern forms a taper portion.

**Claims**

1. A gain-guiding semiconductor laser (10) of planar taper stripe structure comprising:
   a semiconductor substrate (1) having sequentially laminated on one major surface:
   a first clad layer (2),
   an active layer (3),
   a second clad layer (4),
   a capping layer (5), and
   a first electrode (8) of width S1 remote from a light end surface and S2 at said light end surface with an intervening portion where said width changes;
   at least the envelope of said portion changing gently in a tapered manner in width from S1 to S2; and
   a second electrode (9) on the other major surface;
   the distance of an imaginary source of light propagating parallel to a junction surface from said light end surface being D;
   the radius of curvature of an equiphase surface of light emitted from said light end surface being R; and
   the half-value width of a near field pattern of light on said light end surface being W; wherein when said W is selected as a parameter, said D becomes maximum at a certain value of said R and when said W becomes larger, said D becomes larger;

characterized in that:
due to the fact that W is dependant on S2 and
R is dependent on S1, in order to decrease D, said S1 is made larger or smaller than a range in which said D becomes large, and said S2 is made small, to make said R large or small and to make said W small; and in that
the length (L) of said portion is selected to make D less than 10 $\mu$m.

2. A laser (10) according to claim 1 wherein S1 is larger than a range in which D has a large value.

3. A laser (10) according to claim 1 wherein S1 is smaller than a range in which D has a large value.

4. A laser (10) according to claim 1, claim 2 or claim 3 wherein the width of said portion changes gently in a tapered manner from S1 to S2.

**Revendications**

1. Laser à semi-conducteur (10) à guidage par le gain ayant une structure planaire à bande à dimension variant progressivement, comprenant :
   un substrat semi-conducteur (1) ayant, sous forme empilée successivement sur une grande face :
   une première couche de revêtement (2),
   une couche active (3),
   une seconde couche de revêtement (4),
   une couche de couverture (5), et
   une première électrode (8) ayant une largeur S1 à distance de la surface d'émission de lumière et une largeur S2 au niveau de la surface d'émission de lumière, avec une partie intermédiaire dans laquelle la largeur varie,
   l'enveloppe au moins de la partie variant doucement de manière progressive de la largeur S1 à la largeur S2, et
   une seconde électrode (9) placée sur l'autre grande face,
   la distance d'une source imaginaire de lumière qui se propage parallèlement à une surface de jonction depuis la surface d'émission de lumière étant égale à D,
   le rayon de courbure d'une surface isophase de la lumière émise par la surface d'émission de lumière étant égal à R, et
   la largeur à demi-valeur du diagramme en champ proche de la lumière à la surface d'émission de lumière étant égale à W,
   dans lequel, lorsque W est choisi comme paramètre, D prend une valeur maximale pour une certaine valeur de R et, lorsque W augmente, D augmente aussi,
   caractérisé en ce que :
   comme W dépend de S2 et R dépend de S1, S1 est rendue supérieur ou inférieur à une plage dans laquelle D devient plus grand et S2 est rendue petit de manière que R ait une grande ou une petite valeur et que W ait une petite valeur, afin que D diminue, et en ce que
   la longueur (L) de ladite partie est choisie de manière que D soit inférieure à 10 $\mu$m.

2. Laser (10) selon la revendication 1, dans lequel S1 est supérieure à une plage dans laquelle D a une grande valeur.

3. Laser (10) selon la revendication 1, dans lequel la largeur S1 est inférieure à une plage dans laquelle D a une grande valeur.

4. Laser (10) selon la revendication 1, 2 ou 3, dans lequel la largeur de ladite partie varie doucement de manière progressive de S1 à S2.

**Patentansprüche**

1. Verstärkungssteuernder Halbleiterlaser (10) mit einer planaren konusförmigen Streifenstruktur mit einem Halbleitersubstrat (1) mit auf einer Hauptfläche der Reihe nach laminierte Schichten:
   einer ersten platierenden Schicht (2),
   einer Aktivschicht (3),

einer zweiten platierenden Schicht (4),

einer Deckschicht (5), und

einer ersten Elektrode (8) mit einer von der Lichtende-Fläche entfernten Breite S1 und einer Breite S2 an der Lichtende-Fläche mit einem Übergangsbereich, in dem sich die Breite ändert;

wobei sich zumindest die Umhüllung dieses Bereichs konisförmig von der Breite S1 zu der Breite S2 ändert; und

einer zweiten Elektrode (9) auf der anderen Hauptfläche;

wobei eine imaginäre Lichtquelle, die parallel zu der Übergangsfläche abstrahlt, zu der Lichtende-Fläche den Abstand D hat;

wobei eine gleichphasige von der Lichtende-Fläche ausgestrahlten Lichtfläche den Krümmungsradius R hat; und

ein Nahfeld-Lichtmuster auf der Lichtende-Fläche die Halbwertsbreite W hat;

wobei mit W als ein Parameter D bei einem bestimmten Wert von R ein Maximum wird, und wobei mit größer werdendem W D größer wird,

dadurch **gekennzeichnet,**

daß aufgrund der Tatsache, daß W von S2 und R von S1 abhängen, und um D zu verkleinern, S1 größer oder kleiner gemacht wird als ein Bereich, in dem D groß wird, und S2 klein gemacht wird, um R groß oder klein und W klein zu machen; und

daß die Länge (L) des Bereichs ausgewählt wird, um D kleiner als 10 $\mu$m zu machen.

2. Laser (10) nach Anspruch 1, wobei S1 größer ist als ein Bereich, in dem D einen großen Wert hat.

3. Laser (10) nach Anspruch 1, wobei S1 kleiner ist als ein Bereich, in dem D einen großen Wert hat.

4. Laser (10) nach Anspruch 1, 2 oder 3, wobei sich die Breite des Bereichs gleichmäßig konusförmig von S1 nach S2 ändert.

*FIG. 1*

S

A ————————————— A

8

10

6

*FIG. 2*

8  6

7

N    N'    5

N'   P    N    4

3

N    2  10

N    1

9

*FIG. 3*

8

7

P    5

P    4

3

N'   2  10

N    1

9

FIG. 4

FIG. 5

FIG. 6

EP 0 135 594 B1

FIG. 7

FIG. 8

*FIG. 9*

*FIG. 10*